# EUROPEAN PATENT SPECIFICATION

(11) **EP 1 141 443 B1**
(45) Date of publication and mention of the grant of the patent: **14.01.2004**
(21) Application number: 99945965.4
(22) Date of filing: 04.10.1999
(51) Int. Cl.: C23C 18/20, C23C 14/20, C23C 18/54, C25D 5/56

(54) **A METHOD OF METALLIZING THE SURFACE OF A SOLID POLYMER SUBSTRATE AND THE PRODUCT OBTAINED**
VERFAHREN ZUM METALLISIEREN DER OBERFLÄCHE EINES FESTEN POLYMERSUBSTRATES UND SO ERHALTENES PRODUKT
PROCEDE DE METALLISATION DE LA SURFACE D'UN SUBSTRAT POLYMERE SOLIDE ET PRODUIT AINSI OBTENU

(30) Priority: 02.10.1998 DK 124798
(43) Date of publication of application: 10.10.2001
(73) Proprietor: NKT Research & Innovation A/S, 3460 Birkeroed (DK)
(72) Inventor: GLEJBOL, Kristian, DK-2620 Albertslund (DK); WINTHER-JENSEN, Bjorn, DK-2100 Copenhagen (DK)
(74) Representative: Hegner, Anette
(86) International application number: PCT/DK1999/000523
(87) International publication number: WO 2000/020656

(56) References cited:
- EP-A- 0 640 474
- WO-A-97/37844
- US-A- 5 288 541
- DATABASE WPI, week 198935, Derwent Publications Ltd., London, GB, Class G11B, AN 1989-252964, XP002900869 JP 01 184741 A (FUJITSU LTD) 27 July 1989

## Description

The present invention relates to a method of metallizing the surface of polymer substrates such as polyolefins, fluorine containing polymers, polyalkylenes, polyarylenes and mixtures thereof and the product obtained.

Polymer surfaces with low surface energy such as untreated or unmodified polymer substrates are in general difficult to metallize using conventional methods based on electroless or galvanic plating methods.

One approach to obtain metallization on polymer surfaces is given in US 3,801,368, based on the fact that an electroless plating from a solution can be carried out, provided that the surface is first doped using noble metals like Au or Pt. The doping of the surface with noble metals prior to plating is, according to US 3,801,368, carried out by a vacuum evaporation or sputtering process. The advantage of using this type of process is that the energy of the metal-atoms hitting the surface often is sufficient to ensure a good bonding between the subsequently plated metal-film and the polymer surface.

The method described in US 3,801,368 is not universally applicable, but limited to certain polymers. Prior to the doping of the surface by noble metals, it is thus often necessary to modify the chemical composition of the surface, in order to obtain sufficient adhesion between the subsequently plated film and the polymer surface.

The required change of chemical composition, or surface treatment, depends on the substrate to be treated. Corona treatment is widely employed. The corona discharge consists of a number of small sparks created between the substrate surface and a counter electrode (a silent discharge). Most often this treatment is carried out in ambient atmosphere, and results in erosion of the surface as well as in a generation of free radicals due the energy density of the discharges and the reactivity of the atmosphere. One of the problems regarding this method is, that it is not suited for treatment prior to metallizing strongly curved surfaces or surfaces with many cavities. Other problems relate to the limited control over the resulting chemical composition of the surface.

Often a simple corona treatment is not sufficient and more specialised methods has to be employed to ensure a sufficient adhesion.

One possible method is described in WO 97/37844, where a method to obtain a coupling layer between the surface to be plated and the plated metal-film is described. According to WO 97/37844, the coupling layer is formed by vacuum deposition of a monomer on the surface, which is subsequently polymerised by an irradiation process. To ensure a good coupling between the surface and the coupling layer, and between the coupling layer and the plated metal film, plasma-treatment can be used. This process is especially suited for treatment of polymer films of infinite lengths, as the different processes (plasma-treatment, deposition of coupling layer and polymerisation of coupling layer) are carried out at different, separate, stations.

The nature of this process makes it furthermore not suitable for treatment of fluorine containing polymers like poly-tetra-fluoro-ethylene (PTFE).

A number of patents describe methods for electroless plating of PTFE. In JP 92-240189 a PTFE substrate is irradiated with UV laser in the presence of amine or amide followed by an immersing in an electroless metal plating bath. This results in a good bonding of the plated metal to the substrate. However, this method is very difficult to control and also very expensive.

US 3,956,535 discloses a further method of metallization where the object to be metallized is coated with a film having incorporated therein a hydrolysed metal complex. Upon this metal complex a metal or metal ion is adsorbed and acts as catalyst for autocatalytic metal deposition. This method is not usable on many types of polymer substrates due to poor adhesion between the coated film and the substrate.

Also US 4,952,286 describes a method which includes immersing an article to be plated into an electrolytic bath containing dissolved plating metal. Before immersing, the surface has been provided with areas of catalytic metal chalcogenide coating to be converted to a chemical resistant metal-coating.

US 4,057,663 describes a method to make hydrophobic polymers suitable for electroless plating using a concentrate containing P₂O₅. This method is particularly suitable for polymers containing fluor, but not very useful for other polymers.

US 4,919,768 discloses another expensive method of metallization, where non-conducting surfaces are provided with a metal sulphide coating, acting as a base for direct electroplating.

Common to the above mentioned methods are, that they are either very expensive, complicated to use or not applicable to various types of polymer substrates.

The object of the present invention is to provide an industrially applicable method of binding a metal layer to a polymer substrate, which method does not comprise the above mentioned problems, resulting in good binding strength, and can be used on most polymer substrates.

Another object of the present invention is to provide a fast method of binding a metal layer to a polymer surface, and thereby provide a good binding strength.

A further object of the present invention is to provide a method of metallizing a polymer surface, which does not result in any severe depolymerisation of the polymer substrate, in particular when the substrate material exhibits fluorine and/or tertiary carbon atoms, and by use of which method the surface affinity against the metal is improved.

A further object of the present invention is to provide a metallized polymer surface, which can be enhanced by electrochemical deposition using any conventional method.

Another object of the present invention is to provide a method for metallizing a polymer substrate, which method is economical acceptable.

A further object of the present invention is to provide a method for metallizing a polymer substrate, which method is uncomplicated to use.

These objects are achieved by a method of metallizing a surface of a solid polymer substrate as defined in claim 1.

Step b) may start before step a) provided that step b) does not terminate until step a) is started, simultaneously with step a), under step a), or follow immediately, after step a). Step c) may start before step b), simultaneously with step b), follow immediately after step b) or within 8 months after step b), preferably within 6 months. And step d) may follow step c) or start simultaneously with step c).

The method is preferably carried out in a reactor at least partly evacuated from air and water vapour. Further, the reactor should have a channel for feeding the working gas, and a channel for feeding the monomer or monomer mixture. The monomer or monomer mixture is introduced as a gas, e.g. by evaporation from a bottle.

Gas is fed into the reactor, and the plasma is generated (step a). Before, simultaneously or shortly thereafter monomer or monomer mixture is fed into the reactor (step b).

It is noted that the polymerisation preferably should be carried our at plasma discharge parameters resulting in a surface containing chemical groups promoting acid-base reactions with the subsequently deposited metal layer.

The generation step a) is preferably, as stated in claim 11, carried out for a period of between 0.01 and 1000 seconds, preferably between 1 and 500 seconds, more preferably between 10 and 60 seconds, and the treatment step b) is preferably carried out for a period of between 0.1 and 1000 seconds, preferably between 1 and 500 seconds, more preferably between 10 and 200 seconds.

The treatment step b) may continue when step a) has ended, even though there no longer are generated radicals on the substrate surface. This continuation of step b) will then result in a polymerisation of monomers onto the new polymeric layer which already have been bound to the polymer surface.

If the surface of the polymer substrate is contaminated with water, oil or other contaminants, step a) is preferably carried out for more than 30 seconds, and step b) is started 10 to 30 seconds after step a) so as to clean the surface before the monomers are polymerised onto the substrate surface.

The partial pressure of the gas or the plasma in step a) is preferably between 0.1 and 10000 Pa.

The monomer pressure in step b) is preferably, as stated in claim 10, between 0.1 and 10000 Pa, more preferably between 10 and 1000 Pa.

The temperature is not important but should preferably, as stated in claim 14, be the same under both step a) and step b) and preferably the temperature under both step a) and step b) is between 250 and 450 K, most preferably between 280 and 330 K.

The total pressure, i.e. the sum of the partial pressures of the air, optionally water vapour, the gas or plasma and the monomer, under step a) is preferably, as stated in claim 15, equal to the total pressure under step b), the total pressure is preferably between 0.2 and 100000 Pa, more preferably between 0.2 and 10000 Pa, and most preferably between 10 and 1000 Pa.

The polymer substrate can be any polymer material provided that free radicals are created on the surface of the material when it is subjected to a gas plasma or other means of radical generation.

Preferably, as stated in claim 6, the polymer substrate is a polyolefine type, such as PE, PP, or an aryl type, such as styrene, a diene type, such as polybutadiene, polyisoprene, a silicone type, such as silicone rubber, a fluorine type, such as polytetrafluorethylene or its copolymers.

The substrate can have any shape and any size, and may comprise complicated geometries. Preferably the polymer substrate is in the form of film, sheet, pipe, rod, porous or non-porous body, fabric, non-woven fabric, fibres or threads and/or as profiles made by extrusion, compression moulding, injection moulding, thermoforming or vacuum forming.

The generation of radicals on the substrate surface is preferably obtained by subjecting the substrate to a plasma discharge.

The plasma can be generated by any known methods, but preferably, as stated in claim 9, the gas plasma is generated by excitation of a gas in a direct current (DC), low frequency (LF), radio frequency (RF) or microwave (MW) generated electric field. Most preferably the gas plasma is generated by excitation of a gas in a direct current (DC) or by excitation using low frequency (LF).

The intensity of the used gas plasma should preferably have a level ensuring creation of radicals in the polymer surface. If the level is too high, this may result in severe damage of the bulk-polymer (depolymerisation). Hence, the power level of the plasma should be optimised so that surface radicals are created, but no serious damage is made to the bulk.

A preferred method of generating a plasma discharge is described in the applicant's European patent application No. EP 96610018.2, publication No. EP 0 741 404.

Preferred embodiments for the invention are specified in claims 2 - 15.

### Experimental systems

Although it is possible to carry out all necessary steps in a single vacuum vessel, initial experiments were carried out in two separate systems. In one of the systems the virgin polymer surface was altered by the use of a plasma treatment using a working gas and monomers. In the other vacuum system metal atoms were subsequently deposited to the surface of the test samples. Although possible in an industrial production, the approach of using separate machines for the two steps is highly inefficient. The results obtained from these experiments do, however, reflect the results obtainable if a custom made system, able to perform both tasks is used.

The first step was on all samples carried out in an experimental plasma system, essentially consisting of a 22 litre vacuum vessel having two inlet channels for gas and for monomer, respectively, and an electrode arrangement as described above with reference to the applicant's EP application No. 96610088.2 publication No. EP 0 741 404. The plasma is generated using the 3-phase technique described above with a frequency of 50 Hz and Uₒ of 240 to 280V. 27 electrodes are arranged in a circle around the vacuum vessel with a diameter of 17 cm. Every third of the electrodes is connected to Uᵣ, another every third of the electrodes is connected to Uₛ, and the last every third of the electrodes is connected to Uₜ .

The second step was on all samples carried out in an experimental plasma system, essentially consisting of a glass bowl having an internal volume of 15 litres. To atomise the metal and transfer it from the target to the sample surface a custom made magnetron was constructed. The magnetron is essentially a copper plate, having a diameter of 10 cm and a thickness of 4 mm. The back-side of the copper plate is shielded using a ceramic container. On the backside of the copper-plate a magnet is mounted. The magnetron is operated by applying a negative DC potential of 450 V. During operation a current of 0.05 A is drawn between the magnetron and the positive parts of the chamber. During all experiments argon is used as the working gas for the magnetron.

Both plasma systems are pumped using the same vacuum system comprising an Edwards EH 250 Roots-blower, backed by an Alcatel rotary vane pump. The pressure is monitored using an Alcatel pirani-gauge, mounted on the start of the pumping-line.

During step a) and b) the sample is held at floating potential.

### Example 1

Covering a 100x50x3 mm sheet of polytetraflourethylene (PTFE) with a conductive layer of metal.

### Step 1

The sheet was subjected to an argon plasma discharge, generated as described above, for 20 s at a pressure of 0.1 mbar. Hereafter a vapour essentially comprising of 2-ethyl cyano acrylate and glycidylmetacrylate was let into the argon plasma at a pressure of 0.15 mbar for 30 s.

### Step 2

After this treatment 100 nm of silver (Ag) was deposited onto the surface, making the surface conductive. The deposition was accomplished by using a silver sheet as a target on the magnetron, and the magnetron was operated for 60 seconds.

### Step 3

After Ag deposition, the sheet was immersed in an electroless copper bath, ("Shipley Cuposit 251 electroless copper"). Due to the combined treatment in step 1 and 2 an adherent copper coating was formed where Ag was deposited.

The copper layer can be 0.5 µm or more, depending on the treatment time in the electroless copper bath. The average thickness obtained after a given time is as claimed by Shipley 2.5 µm per hours.

The adhesion strength of the copper layer was examined by the standard well known to people skilled in the art, DIN 53 151 having a scale from GT 0 to GT 5, where zero is excellent. The treated sample in this example complied the standard and got the score Gt 0 - Gt 1.

### Example 2

Covering of a component made from polypropylene (PP) with a shielding metallic layer.

### Step 1

The component was subjected to an argon plasma as described above for 10 s at a pressure of 1 mbar. Hereafter a vapour essentially comprising of tolouene-2,4-diisocyanate was let into the plasma chamber at a pressure of 2 mbar for 20 s.

### Step 2

After this treatment 2 ML (monolayers) of platinum (Pt) was accomplished by using a Pt sheet as a target on the magnetron, and the magnetron was operated for 5 seconds.

### Step 3

The component was immersed in an electroless copper bath, ("Shipley Cuposit 251 electroless copper"). Due to the combined treatment in steps 1 and 2 an adherent copper coating was formed where Pt was deposited on the PP component.

### Example 3

Covering a PTFE surface with a 0.5 µm metal layer.

Steps 1 and 2 were conducted as described in example 2.

### Step 3

The component was immersed in an electroless copper bath, ("Shipley Cuposit 251 electroless copper"). Due to the combined treatment in steps 1 and 2 an adherent copper coating was formed where Ag was deposited.

### Example 4a

Covering a PTFE surface with a 5 µm metal layer.

Steps 1 - 2 identical to the steps in example 2.

### Step 3

Copper was then deposited on the Ag covered surface using a conventional electroplating technique.

### Example 4b

Covering a PTFE surface with a 5 µm metal layer
Steps 1 - 3 identical to the steps in example 3

### Step 4

More copper was then deposited on the surface using a conventional electroplating technique.

## Claims

1. A method of metallizing a solid polymer substrate comprising the steps of
a) generating radicals on the substrate surface by subjecting it to a gas plasma, the intensity of the plasma having a level ensuring creation of radicals in the polymer surface so that the bulk-polymer is not depolymerised.
b) forming a layer on the surface using a plasma enhanced polymerisation process employing one or more monomers comprising monomers selected among cyano acrylate, mono- and diacrylates, such as acrylic acid, triethylen glycol diacrylate, glycidyl acrylate, isocyanates, preferably selected from the group consisting of 1,4-diisocyanobutane, toluenediisocyanate, epoxy compounds, such as glycidyl methacrylate, preferably 2,3-epoxypropyl methacrylate, allylic and vinylic compounds, preferably selected from the group consisting of vinyl acetic acid, vinyl norbonene, vinyl pyrrolidone, vinyl trimethoxysilane, vinyl trimethylsilane allylene, allylalcohol, allyloxymethylsilane, allylphenol, allylurea 1-allyltheourea(thiosineamine),
c) providing a short surface deposition using a PVD or CVD process to deposit metal atoms, such as copper, tin, silver palladium, platinum, or gold, and
d) optionally providing a metallization of the surface by using a conventional electroless bath, or avoiding electroless metallization by using direct electrolytic metallization, when the metal layer formed in c) has a thickness allowing electrolytic metallization.

2. A method according to claim 1, wherein the metal layer comprises Pt, Ag, Pd, Cu and Au.

3. A method according to claim 1, wherein the monomer or monomer mixture comprises one or more of cyanoacrylate and glycidyl metacrylate, preferably 2,3-epoxypropyl methacrylate.

4. A method according to each of the preceding claims 1, 2 or 3, wherein step b) comprises treatment of the surface with a monomer vapour comprising 0.5 to 90 mole-%, preferably between 10 and 60 mole % of 2-ethyl cyano acrylate vapour.

5. A method according to claim 4, wherein the monomer prior to the vaporisation consists essentially of 2-ethyl cyano acrylate, an acid having a partial vapour pressure in the plasma which is lower than the partial vapour pressure of 2-ethyl cyano-acrylate, and up to 40 weight-% of another filler, preferably an acid having a partial vapour pressure in the plasma which is lower than half the partial vapour pressure of 2-ethyl cyano-acrylate, most preferably the acid is a polyphosphoric acid and is present prior to the vaporisation in a concentration up to 10 weight-%.

6. A method according to each of the preceding claims, wherein the polymer substrate is a polyolefine type, such as PE, PP, or an aryl type, such as styrene, a diene type, such as polybutadiene, polyisoprene, a silicone type, such as silicone rubber, a fluorine type, such as polytetrafluorethylene or its copolymers.

7. A method according to each of the preceding claims 1-5, wherein the polymer substrate is a PTFE or a PP.

8. A method according to each of the preceding claims, wherein the polymer substrate is an injection moulded polymer component, a polymer fibre, a polymer thread or a polymer filler.

9. A method according to each of the preceding claims, wherein step a) comprises the generation of radicals by use of a gas plasma generated by excitation of the gas in a direct current (DC), low frequency (LF), audio frequency (AF), radio frequency (RF) or microwave generated electric field.

10. A method according to claim 9 wherein the gas plasma is generated in a low frequency (LF) or an audio frequency (AF) generated electric field of a plasma system, said plasma system comprising an electrode arrangement having electrodes arranged so that every third electrode is connected to different voltages.

11. A method according to each of the preceding claims, wherein the monomer pressure in step b) is between 0.1 and 100000 Pa, preferably between 10 and 1000 Pa.

12. A method according to each of the preceding claims, wherein the generation step a) is carried out for a period of between 0.01 and 1000 seconds, and the treatment step b) is carried out for a period of between 0.1 and 1000 seconds.

13. A method according to claim 12, wherein step a) is carried out for more than 30 seconds, and step b) is started 10 to 30 seconds after step a).

14. A method according claim 12, wherein the generation step a) is carried out for a period of between 10 and 60 seconds, and the treatment step b) is carried out for a period of between 10 and 200 seconds.

15. A method according to each of the preceding claims, wherein the temperature is the same under both step a) and step b), and preferably the temperature under both step a) and step b) is between 250 and 450 K, most preferably between 280 and 330 K.

16. A method according to each of the preceding claims, wherein the total pressure under step a) is equal to the total pressure under step b), the total pressure is preferably between 0.2 and 100000 Pa, more preferably between 0.2 and 10000 Pa, and most preferably between 10 and 1000 Pa.

17. A method according to claim 1, where step b) starts before step a) provided that step b) does not terminate until step a) is started, simultaneously with step a), under step a), or follows immediately after step a); where step c) starts before step b), simultaneously with step b), follows immediately after step b) or within 8 months after step b), preferably within 6 months; and where step d) follows step c) or starts simultaneously with step c).

18. A polymer substrate metallized according to the method of each of the preceding claims 1-17.

## Patentansprüche

1. Verfahren zum Metallisieren eines festen Polymersubstrats, umfassend die Schritte:
(a) Erzeugen von Radikalen an der Substratoberfläche durch Einwirken eines Gasplasmas, dessen Intensität einen Wert aufweist, der die Entstehung von Radikalen in der Polymer-Oberfläche in der Weise gewährleistet, daß die Polymermasse nicht depolymerisiert wird,
(b) Ausbilden einer Schicht auf der Oberfläche unter Verwendung eines plasmaverstärkten Polymerisationsprozesses, der mit einem oder mehreren der folgenden Monomere arbeitet: Cyanacrylat, Mono- und Diacrylate, wie Acrylsäure, Triäthylenglykol, Diacrylat, Glycidylacrylat, Isocyanate, vorzugsweise ausgewählt aus der Gruppe 1,4-Diisocyanobutan, Toluoldiisocyanat, Epoxyverbindungen, wie Glycidylmethacrylat, vorzugsweise 2,3-Epoxypropylmethacrylat, allylische und vinylische Verbindungen, vorzugsweise ausgewählt aus Vinylessigsäure, Vinylnorbonen, Vinylpyrrolidon, Vinyltrimethoxysilan, Vinyltrimethylsilanallylen, Allylalkohol, Allyloxymethylsilan, Allylphenol, Allylharnstoff, 1-Allylthioharnstoff (Thiosinamin),
(c) Durchführen eines kurzen Oberflächenniederschlags unter Verwendung eines PVDoder CVD-Prozesses zum Auftragen von Metallatomen, wie Kupfer, Zinn, Silber, Palladium, Platin oder Gold, und
(d) wahlweises Durchführen einer Metallisierung der Oberfläche unter Verwendung eines herkömmlichen elektrodenlosen Bades oder
Vermeiden einer elektrodenlosen Metallisierung unter Anwendung einer direkten elektrolytischen Metallisierung, wenn die im Schritt (c) gebildete Metallschicht eines Dicke aufweist, die eine elektrolytische Metallisierung gestattet.

2. Verfahren nach Anspruch 1, wobei die Metallschicht Pt, Ag, Pd, Cu und Au umfaßt.

3. Verfahren nach Anspruch 1, wobei das Monomer oder Monomergemisch Cyanacrylat und/oder Glycidylmethacrylat, vorzugsweise 2,3-Epoxypropylmethacrylat, umfaßt.

4. Verfahren nach einem der vorhergehenden Ansprüche, wobei der Schritt (b) die Behandlung der Oberfläche mit einem Monomerdampf umfaßt, der 0,5 bis 90 Mol-%, vorzugsweise zwischen 10 und 60 Mol-%, 2-Ethylcyanacrylat-Dampf umfaßt.

5. Verfahren nach Anspruch 4, wobei das Monomer vor der Verdampfung im wesentlichen aus 2-Ethylcyanacrylat, einer Säure mit einem Teildampfdruck in dem Plasma, der unter dem Teildampfdruck von 2-Ethylcyanacrylat liegt, und bis zu 40 Gew-% eines weiteren Füllstoffs besteht, vorzugsweise einer Säure mit einem Teildampfdruck in dem Plasma, der unter dem halben Teildampfdruck von 2-Ethylcyanacrylat liegt, wobei die Säure vorzugsweise eine Polyphosphorsäure ist und vor der Verdampfung in einer Konzentration von bis zu 10 Gew-% vorliegt.

6. Verfahren nach einem der vorhergehenden Ansprüche, wobei das Polymersubstrat ein solches des Polyolefintyps, wie PE, PP, oder des Aryltyps, wie Styrol, oder des Dientyps wie Polybutadien, Polyisopren, des Silicontyps, wie Siliconkautschuk, des Fluortyps, wie Polytetrafluorethylen oder dessen Copolymere, ist.

7. Verfahren nach einem der Ansprüche 1 bis 5, wobei das Polymersubstrat ein PTFE oder ein PP ist.

8. Verfahren nach einem der vorhergehenden Ansprüche, wobei das Polymersubstrat eine Spritzguß-Polymerkomponente, eine Polymerfaser, ein Polymerfaden oder ein Polymerfüllstoff ist.

9. Verfahren nach einem der vorhergehenden Ansprüche, wobei der Schritt (a) die Erzeugung von Radikalen unter Verwendung eines Gasplasmas umfaßt, das durch Anregung des Gases in einem durch Gleichstrom (DC), Niederfrequenz (LF), Tonfrequenz (AF), Hochfrequenz (RF) oder Mikrowellen erzeugten elektrischen Feld erzeugt wird.

10. Verfahren nach Anspruch 9, wobei das Gasplasma in einem mit Niederfrequenz (LF) oder Hochfrequenz (AF) erzeugten elektrischen Feld eines Plasmasystems erzeugt wird, wobei das Plasmasystem eine Elektrodenanordnung umfaßt, dessen Elektroden so angeordnet sind, daß jede dritte Elektrode an anderen Spannungen liegt.

11. Verfahren nach einem der vorhergehenden Ansprüche, wobei der Monomerdruck im Schritt (b) zwischen 0,1 und 100.000 Pa, vorzugsweise zwischen 10 und 1000 Pa, liegt.

12. Verfahren nach einem der vorhergehenden Ansprüche, wobei der Erzeugungsschritt (a) über eine Zeitspanne zwischen 0,01 und 1000 s und der Behandlungsschritt (b) über eine Zeitspanne zwischen 0,1 und 1000 s durchgeführt wird.

13. Verfahren nach Anspruch 12, wobei der Schritt (a) über mehr als 30 s durchgeführt und der Schritt (b) 10 bis 30 s nach dem Schritt (a) begonnen wird.

14. Verfahren nach Anspruch 12, wobei der Erzeugungsschritt (a) über eine Zeitspanne zwischen 10 und 60 s und der Behandlungsschritt (b) über eine Zeitspanne zwischen 10 und 200 s durchgeführt wird.

15. Verfahren nach einem der vorhergehenden Ansprüche, wobei die Temperatur in beiden Schritten (a) und (b) gleich ist und für beide Schritte vorzugsweise zwischen 250 und 450 K, besonders bevorzugt zwischen 280 und 330 K, liegt.

16. Verfahren nach einem der vorhergehenden Ansprüche, wobei der Gesamtdruck während des Schrittes (a) gleich dem Gesamtdruck während des Schrittes (b) ist und vorzugsweise zwischen 0,2 und 100.000 Pa, insbesondere zwischen 0,2 und 10.000 Pa, besonders bevorzugt zwischen 10 und 1000 Pa, liegt.

17. Verfahren nach Anspruch 1, wobei der Schritt (b) vor dem Schritt (a) beginnt, sofern er nicht vor Beginn des Schrittes (a) endet, oder gleichzeitig mit dem Schritt (a) oder während des Schrittes (a) abläuft oder unmittelbar auf den Schritt (a) folgt; wobei der Schritt (c) vor dem Schritt (b) beginnt oder gleichzeitig mit dem Schritt (b) abläuft oder auf den Schritt (b) unmittelbar oder innerhalb von acht Monaten, vorzugsweise innerhalb von sechs Monaten, folgt; und wobei der Schritt (d) auf den Schritt (c) folgt oder gleichzeitig mit diesem beginnt.

18. Polymersubstrat, das gemäß dem Verfahren nach einem der vorhergehenden Ansprüche metallisiert ist.

## Revendications

1. Procédé pour métalliser un substrat polymère solide comprenant les étapes consistant à :
a) engendrer des radicaux libres sur la surface d'un substrat en le soumettant à un plasma gazeux, l'intensité du plasma ayant un degré assurant la création de radicaux libres dans la surface polymère de sorte que la masse de polymère n'est pas dépolymérisée ;
b) former une couche sur la surface en utilisant un procédé de polymérisation favorisé par le plasma employant un ou plusieurs monomères comprenant des monomères choisis parmi le cyanoacrylate, les mono- et di-acrylates, tels que l'acide acrylique, le diacrylate de triéthylèneglycol, l'acrylate de glycidyle, les isocyanates, de préférence choisis dans le groupe formé par le 1,4-diisocyanobutane, le diisocyanate de toluène, les composés époxy, tels que le méthacrylate de glycidyle, de préférence le méthacrylate de 2,3-époxypropyle, les composés allyliques et vinyliques, de préférence choisis dans le groupe formé par l'acide vinylacétique, le vinyl-norbonène, la vinylpyrrolidone, le vinyltriméthoxysilane, le vinyltriméthylsilaneallylène, l'alcool allylique, l'allyloxyméthylsilane, l'allylphénol, l'allylurée, la 1-allylthéo-urée (thiosineamine) ;
c) fournir une courte déposition en surface en utilisant un procédé PVD ou CVD pour déposer des atomes métalliques, tels que le cuivre, l'étain, l'argent, le palladium, le platine ou l'or ; et
d) fournir éventuellement une métallisation de la surface en utilisant un bain autocatalytique classique ; ou éviter la métallisation autocatalytique en utilisant une métallisation électrolytique directe, quand la couche métallique formée en c) présente une épaisseur permettant la métallisation électrolytique.

2. Procédé selon la revendication 1, dans lequel la couche métallique comprend Pt, Ag, Pd, Cu et Au.

3. Procédé selon la revendication 1, dans lequel le monomère ou le mélange de monomères comprend un ou plusieurs éléments parmi le cyanoacrylate et le méthacrylate de glycidyle, de préférence le méthacrylate de 2,3-époxypropyle.

4. Procédé selon l'une quelconque des revendications précédentes 1, 2 ou 3, dans lequel l'étape b) comprend le traitement de la surface avec une vapeur de monomère comprenant 0,5 à 90% en moles, de préférence entre 10 et 60% en moles de vapeur de cyanoacrylate de 2-éthyle.

5. Procédé selon la revendication 4, dans lequel le monomère avant la vaporisation se compose essentiellement de cyanoacrylate de 2-éthyle, un acide ayant une pression partielle de vapeur dans le plasma qui est inférieure à la pression partielle de vapeur du cyanoacrylate de 2-éthyle, et jusqu'à 40% en poids d'une autre charge, de préférence un acide ayant une pression partielle de vapeur dans le plasma qui est inférieure à la moitié de la pression partielle de vapeur du cyanoacrylate de 2-éthyle, de façon tout particulièrement préférée, l'acide est un acide polyphosphorique et est présent avant la vaporisation à une concentration allant jusqu'à 10% en poids.

6. Procédé selon l'une quelconque des revendications précédentes, dans lequel le substrat polymère est un type polyoléfine, telle que PE, PP ou un type aryle, tel que le styrène, un type diène, tel que le polybutadiène, le polyisoprène, un type silicone, telle que le caoutchouc de silicone, un type fluoré, tel que le polytétrafluoréthylène ou ses copolymères.

7. Procédé selon l'une quelconque des revendications précédentes 1 à 5, dans lequel le substrat polymère est un PTFE ou un PP.

8. Procédé selon l'une quelconque des revendications précédentes, dans lequel le substrat polymère est un composant polymère moulé par injection, une fibre polymère, un brin polymère ou une charge polymère.

9. Procédé selon l'une quelconque des revendications précédentes, dans lequel l'étape a) comprend la génération de radicaux libres en utilisant un plasma gazeux engendré par l'excitation du gaz dans un champ électrique engendré par un courant continu (CC), une basse fréquence (BF), une audiofréquence (AF), une radiofréquence (RF) ou une hyperfréquence.

10. Procédé selon la revendication 9, dans lequel le plasma gazeux est engendré dans un champ électrique engendré par une basse fréquence (BF) ou une audiofréquence (AF) d'un système de plasma, ledit système de plasma comprenant une disposition d'électrodes dont les électrodes sont disposées de sorte que chaque troisième électrode est connectée à différentes tensions.

11. Procédé selon l'une quelconque des revendications précédentes, dans lequel la pression de monomère dans l'étape b) est comprise entre 0,1 et 100 000 Pa, de préférence entre 10 et 1 000 Pa.

12. Procédé selon l'une quelconque des revendications précédentes, dans lequel la génération de l'étape a) est réalisée pendant une durée comprise entre 0,01 et 1 000 secondes, et le traitement de l'étape b) est réalisé pendant une durée comprise entre 0,1 et 1 000 secondes.

13. Procédé selon la revendication 12, dans lequel l'étape a) est réalisée pendant plus de 30 secondes, et l'étape b) est commencé 10 à 30 secondes après l'étape a).

14. Procédé selon la revendication 12, dans lequel la génération de l'étape a) est réalisée pendant une durée comprise entre 10 et 60 secondes, et le traitement de l'étape b) est réalisé pendant une durée comprise entre 10 et 200 secondes.

15. Procédé selon l'une quelconque des revendications précédentes, dans lequel la température est la même à la fois dans l'étape a) et dans l'étape b), et de préférence la température à la fois dans l'étape a) et dans l'étape b) est comprise entre 250 et 450 K, de façon tout particulièrement préférée entre 280 et 330 K.

16. Procédé selon l'une quelconque des revendications précédentes, dans lequel la pression totale dans l'étape a) est égale à la pression totale dans l'étape b), la pression totale est de préférence comprise entre 0,2 et 100 000 Pa, de façon plus particulièrement préférée entre 0,2 et 10 000 Pa, et de façon tout particulièrement préférée entre 10 et 1 000 Pa.

17. Procédé selon la revendication 1, où l'étape b) commence avant l'étape a) à condition que l'étape b) ne se termine pas jusqu'à ce que l'étape a) soit commencée, simultanément avec l'étape a), dans l'étape a), ou suit immédiatement après l'étape a) ; où l'étape c) commence avant l'étape b), simultanément avec l'étape b), suit immédiatement après l'étape b) ou dans les 8 mois après l'étape b), de préférence dans les 6 mois ; et où l'étape d) suit l'étape c) ou commence simultanément avec l'étape c).

18. Substrat polymère métallisé selon le procédé de l'une quelconque des revendications 1 à 17.
